Europäisches Patentamt

European Patent Office

Office européen des brevets

(19)

(11) EP 0 454 050 B1

(12) **EUROPEAN PATENT SPECIFICATION**

(45) Date of publication and mention
of the grant of the patent:
**29.07.1998 Bulletin 1998/31**

(51) Int Cl.6: **G06F 9/30**, G06F 9/34,
G06F 7/544, H03H 17/00

(21) Application number: **91106507.6**

(22) Date of filing: **23.04.1991**

(54) **Integrated circuit device for processing signals and suitable for performing multiply-accumulation**

Integrierte Schaltung zur Signalverarbeitung geeignet zum Akkumulieren von Produkten

Circuit intégré pour le traitement du signal convenant à l'exécution de somme de produits

(84) Designated Contracting States:
**DE FR GB**

(30) Priority: **25.04.1990 JP 109532/90**

(43) Date of publication of application:
**30.10.1991 Bulletin 1991/44**

(73) Proprietors:
• **KABUSHIKI KAISHA TOSHIBA**
**Kawasaki-shi, Kanagawa-ken 210 (JP)**
• **TOSHIBA MICRO-ELECTRONICS**
**CORPORATION**
**Kawasaki-ku, Kawasaki-shi (JP)**

(72) Inventors:
• **Yoshimoto, Takeshi,**
**c/o Intellectual Property Div.**
**Minato-ku, Tokyo 105 (JP)**
• **Itaya, Yusei, c/o Intellectual Property Division**
**Minato-ku, Tokyo 105 (JP)**

(74) Representative: **Lehn, Werner, Dipl.-Ing. et al**
**Hoffmann Eitle,**
**Patent- und Rechtsanwälte,**
**Postfach 81 04 20**
**81904 München (DE)**

(56) References cited:
EP-A- 212 637       EP-A- 275 170
FR-A- 2 588 980     GB-A- 2 033 624
US-A- 4 608 634

• IEEE MICRO. vol. 6, no. 6, December 1986, NEW
YORK US pages 10 - 27; FRANTZ ET AL.: 'The
Texas Instruments TMS320C25 Digital Signal
Microcomputer'
• IEEE MICRO. vol. 8, no. 6, December 1988, NEW
YORK US pages 30 - 47; FUCCIO ET AL.: 'The
DSP32C: AT&T's Second-Generation
Floating-Point Digital Signal Processor'

EP 0 454 050 B1

## Description

This invention relates to an integrated circuit device for processing signals, which is suitable for performing multiply-accumulation, such as a non-recursive digital filter, hereinafter called "FIR (Finite Impulse Response) filter".

In general, digital signals are processed by repeating algebraic operations, particularly by performing product-cumulation. Since the amount of the operations are excessively large, the digital signal processor (hereinafter called "DSP") dedicated to signal processing employs operation-accelerating devices such as a high-speed multiplier and ALU (Arithmetic and Logic Unit).

Like general microprocessors, DSPs are controlled by programs each consisting of a series of instruction code items. They are designed for general purposes, and hence are able not only to serve as FIR filter, but also to perform ordinary operations. Here, a DSP serving as FIR filter will be explained.

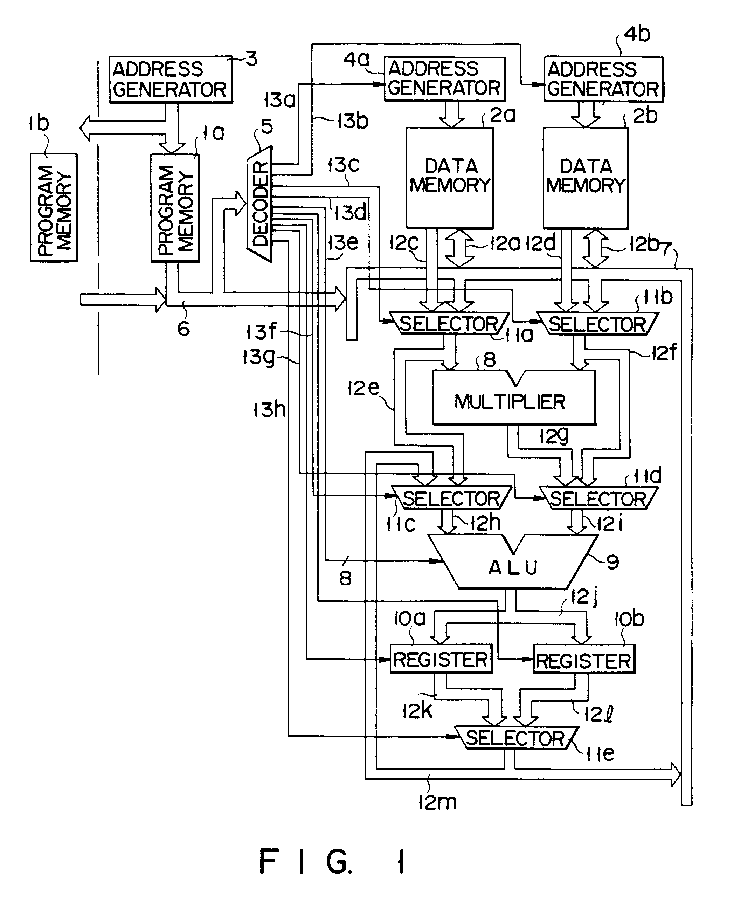

Fig. 1 shows a conventional DSP. As is shown in the figure, a program-address generator 3 generates an address, whereby either a program memory 1a built within the DSP or a program memory 1b provided outside is accessed, and instruction data is read out. An instruction decoder 5 converts the read-out data to control signals 13a - 13h to be supplied to various processing units. The data to be used for operations are stored in data memories 2a and 2b, and have respective addresses to be accessed by data memory-address generators 4a and 4b.

For performing product-cumulation, a multiplier 8 and an ALU 9 are independent from each other, and are connected to each other, by buses 7 and 12a - 12m, which are dedicated to data transmission between the memories 2a and 2b and registers 10a and 10b for storing calculated results. The control signals 13a - 13h output from the instruction decoder 5 are supplied to data bus selectors 11a - 11e for switching the buses, also to the ALU 9 for designating an operation, and to the registers 10a and 10b for latching control.

To increase the processing speed, the buses 7 and 12a - 12m are separated from a program data bus 6, two memories 2a and 2b are employed, and the multiplier 8 and ALU 9 are connected in tandem for performing a great number of product-cumulations. Further, to increase the accessing speed, many DSPs incorporate ROMs for storing, as coefficient data, program data and a part of data to be stored in the data memories.

The calculation performed by the FIR filter is given by

$$y = \sum_{i=1}^{n} a_i \cdot x_i \qquad \qquad \dots (1)$$

where y represents the output of the filter, $x_i$ an input variable, and $a_i$ a coefficient.

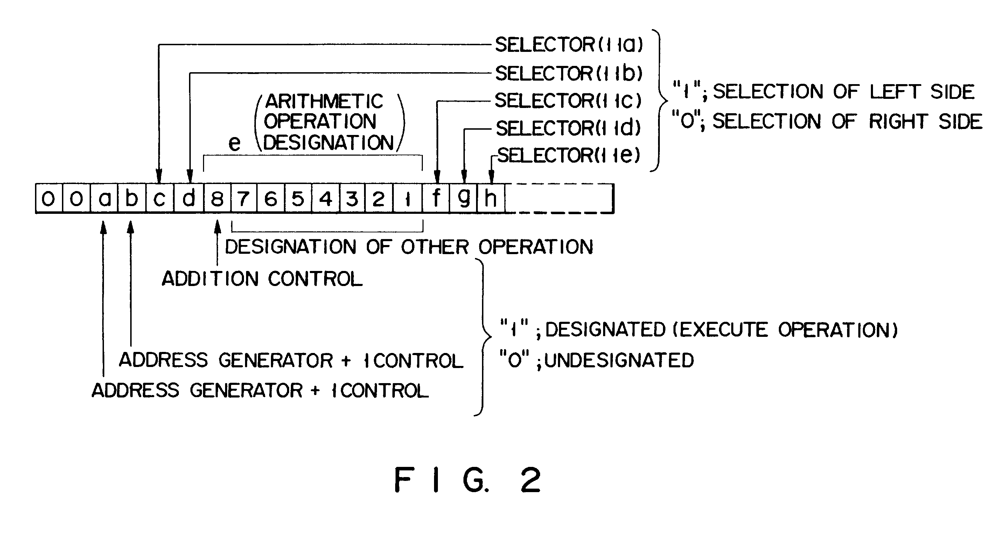

Fig. 2 shows a instruction code to be used in the calculation. The operation of each processing unit is controlled by "0" or "1" designated in a corresponding bit position a - h. The data in the a-bit position instructs whether or not "1" should be added to an address to be generated from the address generator 4a, while the data in the b-bit position instructs whether or not "1" should be added to an address to be generated from the address generator 4b. Each data in bit-positions c, d, f, g, and h controls a corresponding one of the selectors 11a - 11e to select data input from one side thereof when it is "1", and controls it to select data input from the other side when it is "0". The data in the e-bit (8 - 1) positions instruct operations. The data in an 8-bit position thereof designates an addition, and the data in 1 - 7 positions designate operations other than the addition.

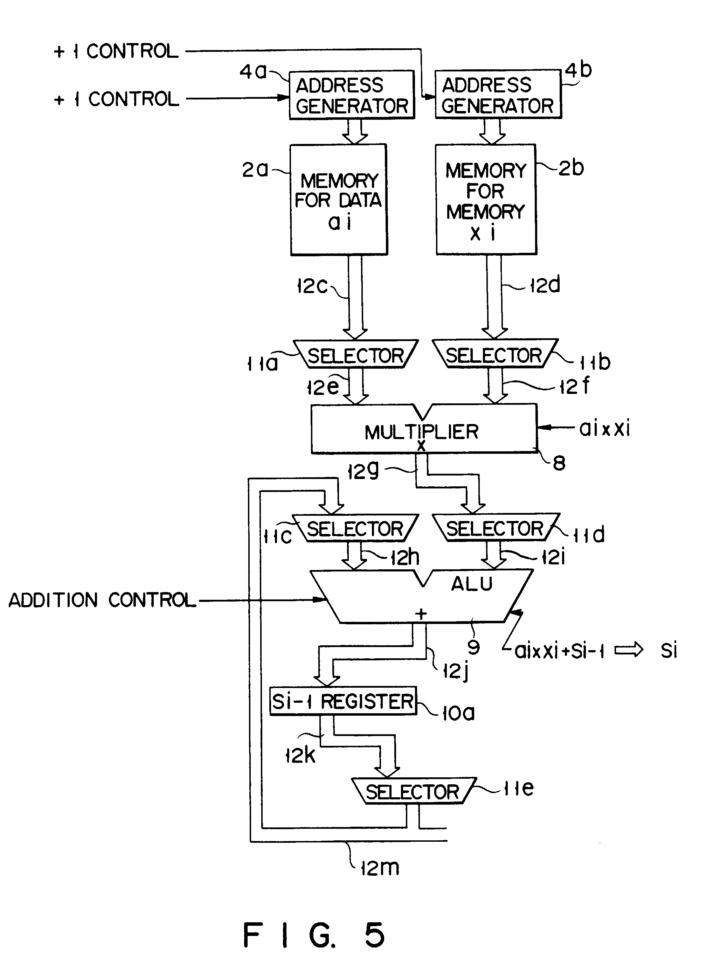

To perform the calculation (1) by means of the above instruction code, n-coefficients $a_i$ and n-input data $x_i$ are stored in the memories 2a and 2b, respectively, as is shown in Fig. 5. Then, the multiplier 8 carries out the multiplication $a_i \cdot x_i$. The operation result is supplied to the ALU 9 and added to the result $S_{i-1}$ which was obtained in the last occasion. Subsequently, the selectors 11a - 11e select processing units, respectively, and control the ALU 9 to perform the addition. Thus, the calculation of the polynomial (1) is performed for one item i (i = 1 to n). Each time the calculation for one item has been performed, the instruction code controls each of the address generators 4a and 4b to increase its address by one, so that the n-coefficients $a_i$ and n-input variables $x_i$ will be accessed subsequently.

The above-described FIR filter has the following disadvantages:

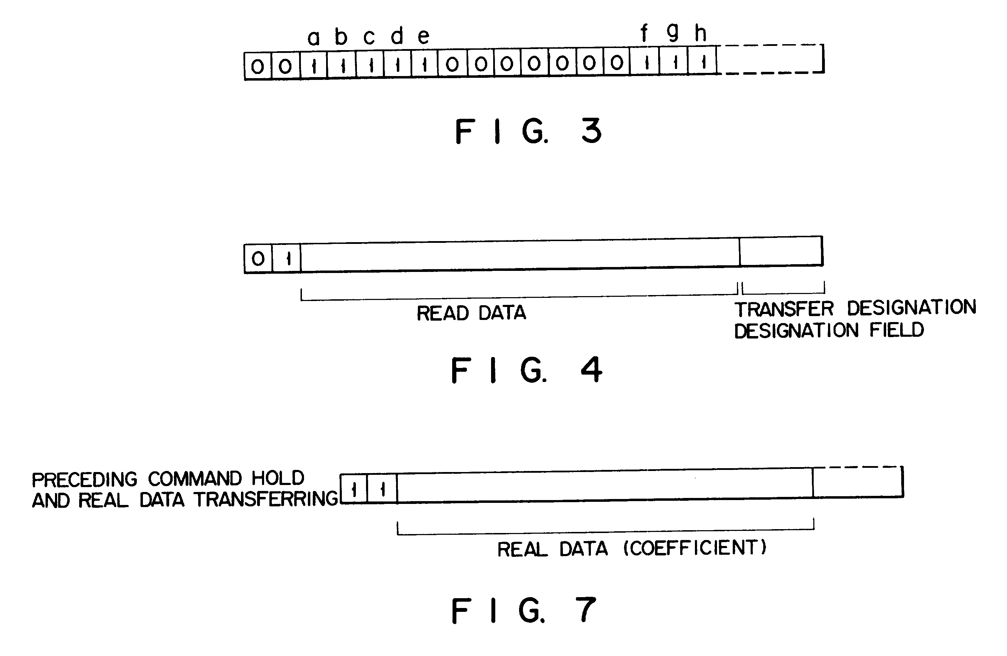

The immediate data items to be loaded in memories exist in the instruction code as shown in Fig. 4, and occupy a greater part of the word length of the code. The larger the number of the immediate data items, the smaller the number of the other data items for instruction the calculation, so that the calculation may be interrupted, resulting in a reduction in calculation efficiency.

Further, for debugging or alteration of the program for the DSP, the DSP must be installed in the system, since the DSP has to be executed in real time.

To determine whether or not the frequency characteristics of the DSP accord to desired ones, or to change them, by using the FIR filter, the coefficient $a_i$ need be adjusted, with the DSP installed in the associated system. To this end, the DSP must operate at a speed identical to that at which it actually operates, and further the program and the coefficient ai must be easily changed. In the conventional DSP, however, the coefficient ai is not stored together with the program, so that it cannot be changed in a way similar to ordinary programs, resulting in a low efficiency.

Moreover, as is shown in Fig.1, the program is stored in a ROM 1b arranged outside the integrated circuit device, or a RAM or EPROM arranged in the device. RAMs stores data less than ROMs. EPROMs are not suitable for high-speed operation, since much access time is required. Thus, a ROM arranged outside is generally used for storing the program. In the case of providing the ROM in the device, terminals for an address bus and a data bus are required.

The same can be said of a memory for the coefficient ai. In the case of providing a ROM in the device, terminals for an address bus and a data bus are required.

To avoid this, it can be thought that the program data and coefficient ai are stored in the same ROM. In this case, however, the program data must be accessed at a time different from that at which the coefficient ai is accessed. This is disadvantageous to the DSP which has to operate at high speed.

ROMs in which data cannot be rewritten are not suitable for storing the coefficient ai in an adaptive-type filter, since the coefficient ai is not a constant in the filter. Thus, to design the DSP for general purposes, it is more advantageous to employ double RAMs than to employ a ROM dedicated to storing the coefficient ai. In the case of using a RAM, however, if the coefficient ai is a constant, the RAM stores constant data at all times, resulting in a low efficiency.

IEEE MICRO, Vol. 6, No. 6, Dec. 1986, pages 10-27, G. A. Frantz et al: "The Texas Instruments TMS320C25 Digital Signal Processor" discloses a digital signal processing system capable of a variety of applications such as digital filtering. According to fig. 1 of this document the system comprises calculation means including data storing means, a multiplier, an adder, data buses and instruction control means including a program memory, an address generator, an instruction decoder and an instruction-code transfer bus. There is disclosed (under "Basic TMS320 architecture" on page 11) that the system eliminates the need for a separate coefficient ROM. In the following, there is described that two large (on-chip) RAM blocks are provided, one of which is configurable either as program or as data memory. The system further comprises an off-chip data memory address space. Further, there is provided an instruction register IR for storing the instruction code read from the program memory. In addition, the system processes data according to a three-level pipeline-processing (fetch-decode-execute).

It is the object of the present invention to provide an integrated circuit device for prosecuting signals which can operate at high speed and also alter the coefficient data with ease and thus operate efficiently.

According to the present invention, this object is solved by an integrated circuit device according to claim 1. The subclaims show advantageous further developments of the integrated circuit device of claim 1.

According to the present invention there is provided a structure which employs two ways of connection, i.e. a direct connection between the program memory and the selector and an indirect connection between them via the register.

In the integrated circuit device of the invention since the coefficient data is stored in the program memory, together with the instruction data, the coefficient data can be altered in a way similar to ordinary programs, and no memories dedicated to storing the coefficient data are required, thereby reducing the number of required terminals.

Further, the invention incorporates a register for storing the instruction code read from the program memory, so that the coefficient data can be accessed continuously without interrupting the operation of the program, and product cumulation and the like can be repeated continuously, thereby reducing the time required for processing. In addition, the data-storing memory need not store the coefficient data at all times, so that the entire area of the memory can be used for storing those variable data other than the coefficient data which are required for calculation.

This invention can be more fully understood from the following detailed description when taken in conjunction with the accompanying drawings, in which:

Fig. 1 is a circuit diagram showing a conventional signal-processing integrated circuit;
Figs. 2 - 4 are views showing a instruction code to be used in the circuit shown in Fig. 1;
Fig. 5 is a block diagram, useful in explaining the operation of a DSP incorporated in the circuit shown in Fig. 1 and serving as FIR filter;
Figs. 6A and 6B are circuit diagrams showing a signal-processing integrated circuit device according to an embodiment of the present invention;
Fig. 7 is a view showing a instruction code to be used in the circuit shown in Figs. 6A and 6B; and
Fig. 8 is a block diagram, useful in explaining the operation of a DSP incorporated in the circuit shown in Figs. 6A and 6B and serving as FIR filter.

The invention will be explained with reference to the accompanying drawings showing an embodiment thereof.

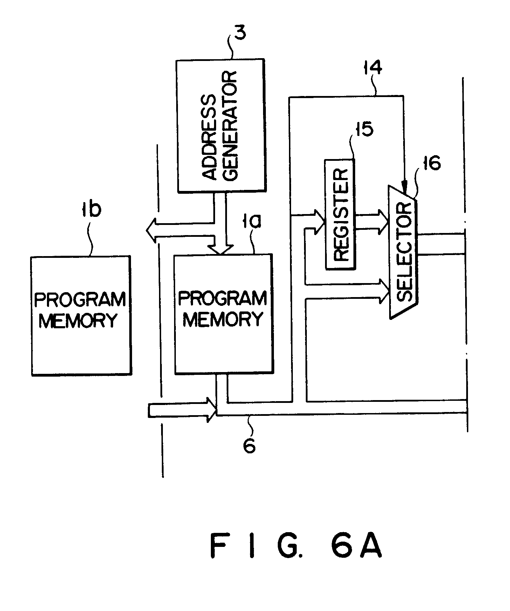

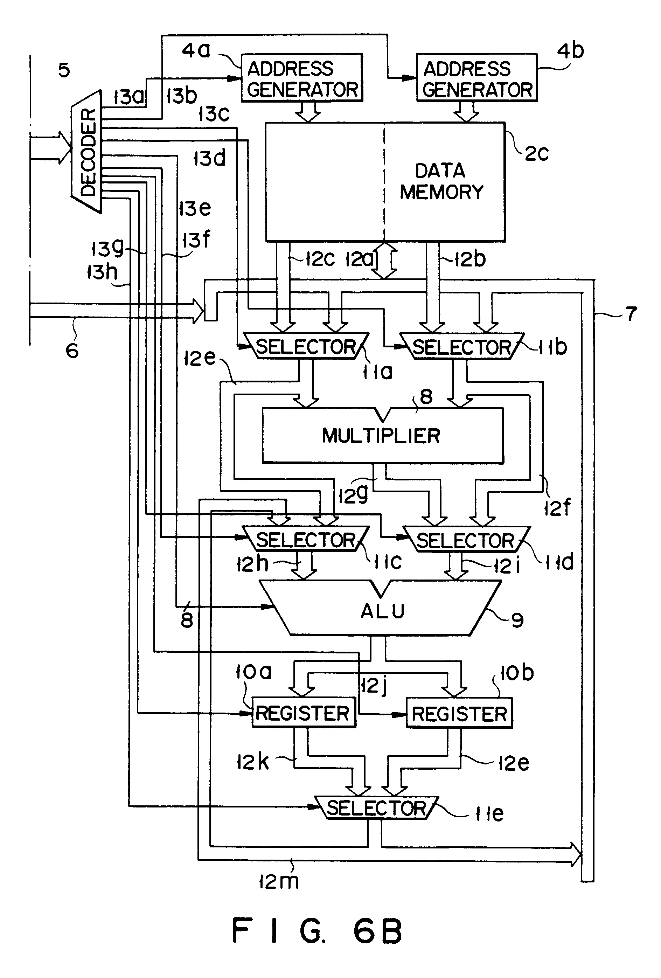

Figs. 6A and 6B show the device of the invention. This device is similar to the conventional one shown in Fig. 4 except that it has a register 15 and a selector 16 both arranged between the program memory 1a and decoder 5. The same elements as those shown in Fig. 4 are designated by the same reference numerals, and explanations thereof are omitted. The register 15 stores a instruction code read out of the memory 1a, while the selector 16 switches program data buses to select either data read out of the register 15 or data read out of the memory 1a. The selector 16 is controlled by most significant bit data in the program data bus.

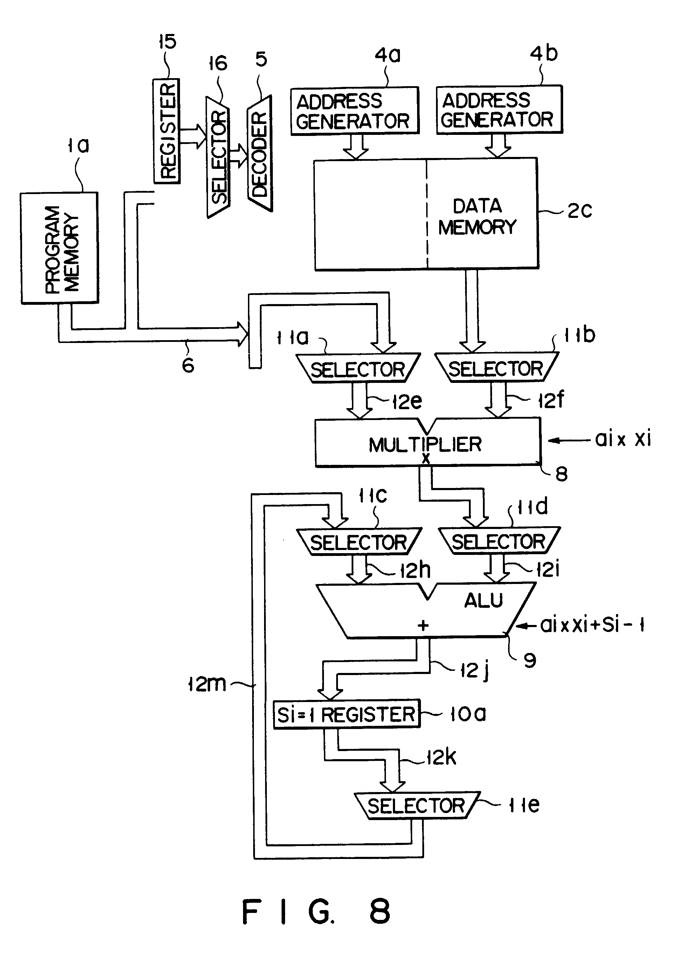

The register 15 stores the instruction code which was used in the calculation performed in the instruction execution cycle immediately before the present cycle. In the present invention, the instruction code shown in Fig. 7 is used which differs from the conventional one in that it has "1" designated in its most signification bit. By virtue of this, when this instruction code is read out of the memory 1a, the register 15 is selected for the decoder 5.

The calculation performed by the DSP serving as FIR filter will now be explained. Fig. 8 is a flowchart of data.

After the instruction code shown in Fig. 3 for making the DSP serve as FIR filter is altered such that data flows as shown in Fig. 8, the altered instruction is effected. The register 15 stores a instruction which was effected in a instruction execution cycle immediately before the present cycle, and the program memory 1a continuously stores an instruction for transferring the immediate data to the program data bus 6. With this structure, the immediate data is transferred as the coefficient ai to the multiplier 8 on a continuous basis.

Since the program memory 1a stores both the instruction code and the coefficient ai, and the instruction is effected without interruption while the coefficient ai is being accessed, the processing speed can be kept at high level.

Further, since the memory 1a serves not only as memory for storing the instruction code but also as memory for storing the coefficient ai, the coefficient ai can be altered in a way similar to ordinary programs, when the program employed is debugged in a state where the DSP is installed. Thus, the altering can be done with high efficiency, and neither a dedicated signal terminal nor a memory dedicated to storing the coefficient ai is required.

Since unlike the conventional device, the coefficients ai need not be stored at all times in the data memory 2c, the entire area thereof can be used for storing the variables xi, thereby enabling the device to be used effectively.

The present invention is not limited to the above-described embodiment. For example, although in the embodiment, a dual-port memory (RAM) is used as the data memory 2c, it may be replaced with such a conventional RAM as consists of independent double memory cell arrays. Further, the structure of the DSP is not limited to that shown in Figs. 6A and 6B. The DSP suffices if it incorporates an operational unit and a memory which can perform, by the use of a coefficient data group, such arithmetic operations as the FIR filter performs, also if a constant coefficient data group is stored in a program memory together with a instruction code, and if a register for storing an instruction code is employed so that calculation will be performed on a continuous basis and the constant coefficient data items are accessed on a continuous basis. The instruction code is not limited to those shown in Figs. 2 - 4, and 7.

In the embodiment, the FIR filter performs product cumulation. The invention, however, is applicable not also to this filter, but also to other cases where calculation is repeated by the use of a coefficient data group and a variable data group.

In addition, although in the embodiment, the command code-storing register 15 is employed, if more than two registers are used alternately, not only a simple-formula calculation but also a complex-polynomial calculation can be repeated.

If it is apprehended that the instruction code which should be stored in the register 15 will be decoded, and that undesired processing will be effected, such a trouble can be avoided only by providing a field for prohibiting decoding.

As is described above, in the invention, the coefficient data group is stored in the program memory together with a instruction code, so that a memory dedicated to storing coefficient data is not required.

Further, a register is employed which stores a command code read out of the program memory, and hence the coefficient data can be accessed on a continuous basis without interrupting the flow of the program, thereby enabling calculation such as product cumulation to be repeated. Thus, the device of the invention can operate at high speed.

Moreover, since the coefficient data group is stored in the program memory together with the instruction code, it can be altered in a way similar to ordinary programs.

Since it is needless to store the coefficient data in the data memory at all times, the entire area of the memory can be used for storing those variable data other than the coefficient data which are required for calculation, which enables the device to be used effectively.

Reference signs in the claims are intended for better understanding and shall not limit the scope.

**Claims**

1. An integrated circuit device for processing digital signals, comprising:

   calculation means including a data-storing memory (2C), a multiplier (8) for receiving data read from data-storing memories and performing multiplication of the data therefrom, an adder (9) for receiving data output from the multiplier and performing accumulation of the data therefrom, data buses (12a - 12l) for connecting the above components to one another, and selectors (11a - 11e) for switching the data buses, the calculation means being controlled by an instruction code; and
   instruction control means including a program memory (1a, 1b) for storing the instruction code and data concerning a coefficient, a program address generator (3) for accessing the program memory, an instruction decoder (5) for decoding the instruction code read from the program memory and transmitting control signals to the calculation means to control it, and an instruction code transfer bus (6) for connecting the program memory to the instruction decoder and data bus (7); characterized in that

said instruction control means further includes a register (15) for storing the instruction code read from the program memory (1a, 1b), and a selector (16) connected to the register (15), the program memory (1a, 1b) and the decoder (5), selecting inputs from the register and directly from the program memory in response to a predetermined bit of said instruction code, and transmitting outputs to the decoder; and

wherein the instruction code is executed, while coefficient data items are continuously read out from said program memory (1a).

2. An integrated circuit device according to claim 1, wherein said program memory (1a, 1b) comprises a first program memory (1a) provided within the device, and a second program memory (1b) provided outside the device.

3. An integrated circuit device according to claim 2, said first program memory (1a) provided within the device is provided for storing the instruction code and data concerning a coefficient, wherein

said program address generator (3) accesses said first program memory (1a) and said second program memory (1b) and said instruction decoder (5) decodes the instruction code read from said first program memory (1a) and transmits control signals to the calculation means to control it, and said instruction code transfer bus (6) connects the first and second program memories (1a, 1b) to the instruction decoder through said selector (16); wherein
said device further comprises:
a data bus terminal for receiving data read from said second program memory (1b).

4. An integrated circuit device according to claim 3, wherein said register (15) stores the instruction code read from said first program memory (1a).

**Patentansprüche**

1. Integrierte Schaltungseinrichtung zur Verarbeitung von digitalen Signalen, umfassend:

eine Berechnungseinrichtung mit einem Datenspeicherungs-Speicher (2c), einem Multiplizierer (8) zum Empfangen von Daten, die aus den Datenspeicherungs-Speichern ausgelesen werden, und zum Ausführen einer Multiplikation der Daten davon, einem Addierer (9) zum Empfangen von Daten, die von dem Multiplizierer ausgegeben werden, und zum Ausführen einer Akkumulation der Daten davon, Datenbussen (12a - 12l) zum Verbinden der obigen Komponenten miteinander, und Wählern (11a - 11e) zum Umschalten der Datenbusse, wobei die Berechnungseinrichtung von einem Befehlscode gesteuert wird; und

eine Befehlssteuereinrichtung mit einem Programmspeicher (1a, 1b) zum Speichern des Befehlscodes und von Daten betreffend einen Koeffizienten, einem Programmadressengenerator (3) zum Zugreifen auf den Programmspeicher, einem Befehlsdecoder (5) zum Decodieren des aus dem Programmspeicher ausgelesenen Befehlscodes und zum Übertragen von Steuersignalen an die Berechnungseinrichtung, um diese zu steuern, und einem Befehlscode-Transferbus (6) zum Verbinden des Programmspeichers mit dem Befehlsdecoder und dem Datenbus (7);

**dadurch gekennzeichnet, daß**

die Befehlssteuereinrichtung ferner umfaßt ein Register (15) zum Speichern des aus dem Programmspeicher (1a, 1b) ausgelesenen Befehlscodes und einen Wähler (16), der mit dem Register (15), dem Programmspeicher (1a, 1b) und dem Decoder (5) verbunden ist, zum Wählen von Eingängen von dem Register und direkt von dem Programmspeicher im Ansprechen auf ein vorgegebenes Bit des Befehlscodes, und zum Übertragen von Ausgängen an den Decoder; und

wobei der Befehlscode ausgeführt wird, während Koeffizientendatenteile kontinuierlich aus dem Programmspeicher (1a) ausgelesen werden.

2. Integrierte Schaltungseinrichtung nach Anspruch 1, dadurch gekennzeichnet, daß der Programmspeicher (1a, 1b) einen ersten Programmspeicher (1a), der innerhalb der Einrichtung vorgesehen ist, und einen zweiten Programmspeicher (1b), der außerhalb der Einrichtung vorgesehen ist, umfaßt.

3. Integrierte Schaltungseinrichtung nach Anspruch 2, dadurch gekennzeichnet, daß der erste Programmspeicher (1a), der innerhalb der Einrichtung vorgesehen ist, zum Speichern des Befehlscodes und von Daten bezüglich eines Koeffizienten vorgesehen ist; wobei

der Programmadressengenerator (3) auf den ersten Programmspeicher (1a) und den zweiten Programmspeicher (1b) zugreift und der Befehlsdecoder (5) den aus dem ersten Programmspeicher (1a) ausgelesenen Befehlscode decodiert und Steuersignale an die Berechnungseinrichtung, um diese zu steuern, überträgt und der Befehlscode-Transferbus (6) die ersten und zweiten Programmspeicher (1a, 1b) mit dem Befehlsdecoder durch den Wähler (16) verbindet, wobei

die Einrichtung ferner umfaßt:

einen Datenbusanschluß zum Empfangen von Daten, die aus dem zweiten Programmspeicher (1b) ausgelesen werden.

4. Integrierte Schaltungseinrichtung nach Anspruch 3, dadurch gekennzeichnet, daß das Register (15) den Befehlscode speichert, der aus dem ersten Programmspeicher (1a) ausgelesen wird.


**Revendications**

1. Un dispositif à circuit intégré pour traiter des signaux numériques, comprenant :

des moyens de calcul comprenant une mémoire d'enregistrement de données (2C), un multiplieur (8) pour recevoir des données qui sont lues dans des mémoires d'enregistrement de données et pour effectuer une multiplication des données provenant de ces mémoires, et un additionneur (9) pour recevoir des données émises par le multiplieur et pour effectuer une accumulation des données provenant de celui-ci, des bus de données (12a - 12l) pour connecter les uns aux autres les composants ci-dessus, et des sélecteurs (11a - 11e) pour commuter les bus de données, les moyens de calcul étant commandés par un code d'instruction; et des moyens de commande d'instruction comprenant une mémoire de programme (1a, 1b) pour enregistrer le code d'instruction et des données concernant un coefficient, un générateur d'adresse de programme (3) pour accéder à la mémoire de programme, un décodeur d'instruction (5) pour décoder le code d'instruction qui est lu dans la mémoire de programme et pour transmettre des signaux de commande aux moyens de calcul, pour les commander, et un bus de transfert de code d'instruction (6) pour connecter la mémoire de programme au décodeur d'instruction et au bus de données (7); caractérisé en ce que les moyens de commande d'instruction comprennent en outre un registre (15) pour enregistrer le code d'instruction qui est lu dans la mémoire de programme (1a, 1b), et un sélecteur (16) connecté au registre (15), à la mémoire de programme (1a, 1b) et au décodeur (5), qui sélectionne des signaux d'entrée provenant du registre et provenant directement de la mémoire de programme, en réponse à un bit prédéterminé du code d'instruction, et qui transmet des signaux de sortie au décodeur; et dans lequel le code d'instruction est exécuté pendant que des éléments de données de coefficient sont lus continuellement dans la mémoire de programme (1a).

2. Un dispositif à circuit intégré selon la revendication 1, dans lequel la mémoire de programme (1a, 1b) comprend une première mémoire de programme (1a) qui se trouve à l'intérieur du dispositif, et une seconde mémoire de programme (1b) qui se trouve à l'extérieur du dispositif.

3. Un dispositif à circuit intégré selon la revendication 2, dans lequel la première mémoire de programme (1a) se trouvant à l'intérieur du dispositif est incorporée pour enregistrer le code d'instruction et des données concernant un coefficient, dans lequel

le générateur d'adresse de programme (3) accède à la première mémoire de programme (1a) et à la seconde mémoire de programme (1b), et le décodeur d'instruction (5) décode le code d'instruction qui est lu dans la première mémoire de programme (1a), et il transmet des signaux de commande aux moyens de calcul pour les commander, et le bus de transfert de code d'instruction (6) connecte les première et seconde mémoires de programme (1a, 1b) au décodeur d'instruction par l'intermédiaire du sélecteur (16); dans lequel le dispositif comprend en outre :

une borne de bus de données pour recevoir des données qui sont lues dans la seconde mémoire de programme (1b).

4. Un dispositif à circuit intégré selon la revendication 3, dans lequel le registre (15) enregistre le code d'instruction qui est lu dans la première mémoire de programme (1a).

F I G. 1

FIG. 2

EP 0 454 050 B1

a b c d e         f g h

| 0 | 0 | 1 | 1 | 1 | 1 | 1 | 0 | 0 | 0 | 0 | 0 | 0 | 1 | 1 | 1 |

**F I G. 3**

| 0 | 1 | | | | | | |

READ DATA             TRANSFER DESIGNATION
                                              DESIGNATION FIELD

**F I G. 4**

PRECEDING COMMAND HOLD
AND REAL DATA TRANSFERRING

| 1 | 1 | | | | | |

REAL DATA (COEFFICIENT)

**F I G. 7**

+ 1 CONTROL

+ 1 CONTROL

4a ADDRESS GENERATOR    ADDRESS GENERATOR 4b

2a MEMORY FOR DATA $a_i$    MEMORY FOR MEMORY $x_i$ 2b

12c    12d

11a SELECTOR    SELECTOR 11b

12e    12f

MULTIPLIER × — $a_i \times x_i$

8

12g

11c SELECTOR    SELECTOR 11d

12h    12i

ADDITION CONTROL    ALU

+

9 — $a_i \times x_i + S_{i-1} \Rightarrow S_i$

12j

$S_{i-1}$ REGISTER 10a

12k

SELECTOR 11e

12m

# F I G. 5

F I G. 6A

F I G.  6B

F I G. 8